# EUROPÄISCHE PATENTANMELDUNG

(11) **EP 1 149 655 A2**
(43) Veröffentlichungstag der Anmeldung: **31.10.2001**
(21) Anmeldenummer: 01105101.8
(22) Anmeldetag: 02.03.2001
(51) Int. Cl.: B23K 20/10

(54) **Ultraschall-Transducer**

(30) Priorität: 02.03.2000 DE 10009965
(71) Anmelder: Hesse & Knipps GmbH, 33100 Paderborn (DE)
(72) Erfinder: Wallaschek, Jörg, Dr.-Ing. Prof., 33106 Paderborn (DE); Hesse, Hans-Jürgen, Dr.-Ing., 33106 Paderborn (DE)
(74) Vertreter: Patentanwälte Lippert, Stachow, Schmidt & Partner

(57) **Zusammenfassung**

Die Erfindung betrifft einen Ultraschall-Transducer, der einerseits mit einem Ultraschall-Schwingungserzeuger und andererseits an seinem schmaleren Ende mit einem Ultraschall-Drahtbondwerkzeug verbindbar ist und für Ultraschall-Drahtbondvorrichtungen zum Herstellen von Ultraschall-Schweißverbindungen zwischen einem Bondkontakt und einem Bonddraht vorgesehen ist.

Der Erfindung liegt daher die Aufgabe zugrunde, einen Ultraschall-Transducer zu schaffen, der eine freizügige Zuführung des Bonddrahtes erlaubt. Gelöst wird die Aufgabe dadurch, dass der Ultraschall-Transducer (1) zwei senkrecht aufeinander stehende Symmetrieebenen aufweist, dass zwei sich nebeneinander erstreckende Schwingungsübertragerarme (2, 3) vorgesehen sind, die gemeinsam den Ultraschall-Transducer (1) bilden, dass die Schwingungsübertragerarme (2, 3) beidends einstückig miteinander verbunden sind und dass sich zwischen den Schwingungsübertragerarmen (2, 3) ein durch die horizontale Symmetrieebene verlaufender und zum Hindurchführen des Bonddrahtes in einem variablen Winkelbereich vorgesehener Schlitz (4) erstreckt.

## Beschreibung

Die Erfindung betrifft einen Ultraschall-Transducer, der einerseits mit einem Ultraschall-Schwingungserzeuger und andererseits an seinem schmaleren Ende mit einem Ultraschall-Drahtbondwerkzeug verbindbar ist und für Ultraschall-Drahtbondvorrichtungen zum Herstellen von Ultraschall-Schweißverbindungen zwischen einem Bondkontakt und einem Bonddraht vorgesehen ist.

In Ultraschall-Drahtbondvorrichtungen werden derartige U1traschall-Transducer zum Weiterleiten von Ultraschall-Schwingungen von einem Ultraschall-Schwingungserzeuger zum Ultraschall-Drahtbondwerkzeug (Wedge) eingesetzt. Insbesondere haben die Ultraschall-Transducer die Aufgabe, die an einem Ende in diese eingeleiteten Ultraschall-Schwingungen zum entgegengesetzten freien Ende weiterzuleiten und dabei gleichzeitig zu verstärken, also die Funktion eines Amplitudentransformators zu realisieren. Aus diesem Grund verjüngen sich die Ultraschall-Transducer entweder kontinuierlich, oder in Stufen, ausgehend von dem Ende, an dem die Ultraschall-Schwingungen eingeleitet werden in Richtung zum freien Ende, an dem das Ultraschall-Drahtbondwerkzeug befestigt ist. Die in den Ultraschall-Transducer eingeleiteten Ultraschall-Schwingungen werden an dessen schmaleres Ende weitergeleitet, dabei gleichzeitig verstärkt und auf das an dieser Stelle montierte Ultraschall-Drahtbondwerkzeug übertragen.

Für die Erzeugung der Ultraschallschwingungen werden üblicherweise elektrisch angeregte magneto- oder piezostriktive Antriebselemente, z.B. Piezostapel, eingesetzt. Diese sind in der Lage, hochfrequente Schwingungen direkt im Ultraschall-Transducer zu erzeugen (magnetostriktive Antriebselemente), oder Ultraschall-Schwingungen extern zu erzeugen (elektrostriktive Antriebselemente). Im Falle der externen Erzeugung der Ultraschall-Schwingungen werden diese durch eine mechanische Kopplung in den Ultraschall-Transducer eingeleitet und erzeugen in diesem eine Längsschwingung.

Diese Längsschwingung wird zum schmaleren Ende des Ultraschall-Transducers übertragen, wobei gleichzeitig, bewirkt durch die Verjüngung des Transducers, eine Verstärkung der Amplitude der Ultraschallschwingungen erfolgt.

Die Ultraschall-Transducer sind meistens als rotationssymmetrisches Bauteil ausgeführt und lassen sich durch diese Form einfach durch Drehen fertigen, wobei als Material üblicherweise Stahl verwendet wird.

Ein Beispiel für einen Ultraschall-Transducer mit magnetostriktiver Schwingungserzeugung zeigt die US 4,040,885 und für einen Ultraschall-Transducer mit piezostriktiver Schwingungserzeugung, d.h. mit einem Stapel von Piezoelementen, die WO 00/67944.

Die Befestigung des Ultraschall-Drahtbondwerkzeuges am Ultraschall-Transducer erfolgt üblicherweise durch Klemmung quer zur Längsachse des Ultraschall-Transducers bzw. der Ultraschall-Schwingungen. Durch diese Befestigung werden die Längsschwingungen auf das Ultraschall-Drahtbondwerkzeug übertragen und verursachen eine Bewegung des Bondwerkzeuges quer zu dessen Längsachse.

Zur Ausführung eines Drahtbondvorganges muss der auf einem Bondkontakt zu befestigende Bonddraht zunächst dem Bondwerkzeug von einer Vorratsspule zugeführt werden. Da das Bondwerkzeug (wedge) üblicherweise als Keilbondwerkzeug ausgeführt ist, muß der Bonddraht in einem vorgegebenen Winkel schräg von hinten zugeführt werden (z.B. 30° oder 60°). Da aber der Bonddraht außerdem exakt parallel zur Schwingungsrichtung unter dem Bndwerkzeug positioniert werden muss, bedeutet das, dass im Ultraschall-Transducer eine quer durch diesen in Drahtzuführungsrichtung (also schräg) verlaufende Bohrung eingebracht werden muss.

Nachteilig hierbei ist, dass durch die im Ultraschall-Transducer eingebrachte Bohrung der Drahtzuführungswinkel fest vorgegeben ist und nicht, bzw. nur in einem sehr engen Toleranzbereich veränderbar ist. Wäre also aus technologischen Gründen im Einzelfall ein anderer Drahtzuführungswinkel erforderlich, müßte der Ultraschall-Transducer ausgebaut und durch einen anderen ersetzt werden.

Darüberhinaus beeinflusst die Position der Bohrung das Schwingungsverhalten des Ultraschall-Transducers.

Der Erfindung liegt daher die Aufgabe zugrunde, einen Ultraschall-Transducer zu schaffen, bei dem die Nachteile des Standes der Technik vermieden werden.

Die der Erfindung zugrundeliegende Aufgabenstellung wird bei einem Ultraschall-Transducer der eingangs genannten Art dadurch gelöst, dass der Ultraschall-Transducer zwei senkrecht aufeinander stehende Symmetrieebenen aufweist, dass zwei sich nebeneinander erstreckende Schwingungsübertragerarme vorgesehen sind, die gemeinsam den Ultraschall-Transducer bilden, dass die Schwingungsübertragerarme beidends einstückig miteinander verbunden sind und dass sich zwischen den Schwingungsübertragerarmen ein durch die horizontale Symmetrieebene verlaufender und zum Hindurchführen des Bonddrahtes in einem variablen Winkelbereich vorgesehener Schlitz erstreckt.

Ein derartiger Ultraschall-Transducer ermöglicht eine vollkommen freizügige Zuführung des zum Drahtbonden erforderlichen Bonddrahtes zwischen den Schwingungsübertragerarmen, so dass auch bei der Verwendung von Bondwerkzeugen mit erheblichen geometrischen Unterschieden eine problemlose Drahtzuführung ermöglicht wird.

Um definierte Schwingungsübertragungsverhältnisse zu erreichen, ist der Querschnitt der Schwingungsübertragerarme über deren gesamten Länge im wesentlichen konstant, wobei sich der Ultraschall-Transducer zur Erzeugung der erwünschten Schwingungstransformation in mindestens einer der Symmetrieebenen verjüngt.

In einer weiteren Ausgestaltung der Erfindung sind wenigstens zwei aus der horizontalen Symmetrieebene nebeneinander hervorstehende und in jeweils einem Schwingungsknoten positionierte Aufhängungen vorgesehen. Mit dieser Ausgestaltung der Erfindung kann der Ultraschall-Transducer an einer Bondeinheit eines Ultraschall-Drahtbonders schwenkbar montiert werden. Soll die Montage hingegen in einer Parallelführung o.dgl. erfolgen, so sieht eine weitere Fortführung der Erfindung zwei nach oben und zwei nach unten aus jeweils einem Schwingungsknoten hervorstehende Aufhängungen vor.

Da während eines Bondvorganges unter Ultraschalleinwirkung durchaus auch Schwingungen quer zur Längsrichtung des Ultraschall-Transducers auftreten können, ist in einer besonderen Ausgestaltung der Erfindung vorgesehen, dass die Aufhängungen in Querrichtung zum Ultraschall-Transducer elastisch und/oder schwingungsdämpfend ausgebildet sind.

Weiterhin schließt der Schlitz eine am vorderen Ende des Ultraschall-Schwingungsübertragers befindliche Aufnahme für das Ultraschall-Drahtbondwerkzeug ein, wobei das Ultraschall-Drahtbondwerkzeug mittels einer Klemmeinrichtung quer zur Schwingungsrichtung der Ultraschall-Schwingungen montierbar ist.

Selbstverständlich ist es auch möglich, das Ultraschall-Drahtbondwerkzeug am vorderen Ende des Ultraschall-Transducers in dessen Längsrichtung zu montieren.

Dadurch, dass der Ultraschall-Transducer zwei senkrecht aufeinanderstehende Symmetrieebenen aufweist, kann dieser einfach durch Drahterodieren hergestellt werden.

Für die Herstellung eines besonders leichten Ultraschall-Transducers ist Titan besonders geeignet.

Eine weitere besondere Ausgestaltung der Erfindung ist dadurch gekennzeichnet, dass als Ultraschall-Schwingungserzeuger ein einzelner Stapel von elektrostriktiven Piezoelementen am Ultraschall-Transducer durch Verschrauben o.dgl. befestigt ist. Damit läßt sich der Ultraschall-Transducer wie üblich betreiben.

Für den Fall, dass jedoch gezielt Längs- und Querschwingungen erzeugt werden sollen, sieht eine Fortführung der Erfindung vor, als Ultraschall-Schwingungserzeuger zwei nebeneinander am Ultraschall-Transducer befestigte Stapel von elektrostriktiven Piezoelementen vorzusehen, die gleich- oder gegenphasig erregt werden. Damit wird auch eine Schwingung des schmalen Endes des Ultraschall-Transducers und damit des dort eingespannten Bondwerkzeuges in Querrichtung erreicht. Alternativ kann auch jedem der Schwingungsübertragungsarme ein Stapel mit elektrostriktiven Piezoelementen zugeordnet werden, oder es wird jedem Schwingungsübertragungsarm ein Teilstapel mit elektrostriktiven Piezoelementen unterschiedlicher Phasenlage zugeordnet.

Die Erfindung soll nachfolgend an einem Ausführungsbeispiel näher erläutert werden.

Die zugehörige Zeichnungsfigur zeigt einen erfindungsgemäß ausgestalteten Ultraschall-Transducer 1 mit zwei senkrecht aufeinander stehenden Symmetrieebenen. Dieser Ultraschall-Transducer 1 weist zwei sich nebeneinander erstreckende Schwingungsübertragerarme 2, 3 auf, die beidends einstückig miteinander verbunden sind. Zwischen den Schwingungsübertragerarmen 2, 3 erstreckt sich ein durch die horizontale Symmetrieebene verlaufender und zum Hindurchführen eines Bonddrahtes in einem variablen Winkelbereich vorgesehener Schlitz 4. Im Interesse einer möglichst einfachen Fertigung durch Erodieren ist der Querschnitt der Schwingungsübertragerarme 2, 3 über deren gesamten Länge im wesentlichen konstant.

Um die erwünschte Schwingungstransformation zu erreichen, verjüngt sich der Ultraschall-Transducer 1 zur Erzeugung einer Schwingungstransformation in mindestens einer der Symmetrieebenen, indem sich der Abstand zwischen den Schwingungsübertragungsarmen 2, 3 in Richtung zum freien Ende des Ultraschall-Transducers 1 verringert. An diesem Ende befindet sich wie üblich eine Aufnahme 9 für ein Ultraschall-Drahtbondwerkzeug. Die Erzeugung und Einleitung von Ultraschallschwingungen in den Ultraschall-Transducer 1 kann mit Hilfe üblicher nicht dargestellter Ultraschall-Schwingungserzeuger erfolgen. Hierzu ist am breiteren Ende des Ultraschall-Transducers 1 eine Schwingungseinkoppelfläche 19 vorgesehen, so dass beispielsweise ein Stapel von elektrostriktiven Piezoelementen auf dieser Fläche z.B. durch Verschrauben befestigt werden kann.

Zur Montage bzw. Befestigung des Ultraschall-Transducers 1 sind Aufhängungen 5, 6, 7, 8 vorgesehen, die aus der horizontalen Symmetrieebene hervorstehen und in jeweils einem Schwingungsknoten des Ultraschall-Transducers positioniert sind.

Da es während des Betriebes des Ultraschall-Transducers 1 immer zu einer, wenn auch geringfügigen Störung der Resonanzfrequenz des schwingenden Systemes kommt, welches im wesentlichen aus Bondwerkzeug/Bonddraht, Ultraschall-Transducer und Ultraschall-Schwingungserzeuger besteht, verschieben sich die aktuellen Schwingungsknoten geringfügig in Längsrichtung des Ultraschall-Transducers. Das führt dazu, dass sich die Aufhängungen vorübergehend nicht genau im Schwingungsknoten befinden, so dass Ultraschall-Schwingungen, insbesondere Querschwingungen, auf die Aufhängungen übertragen werden

Um die Übertragung von Schwingungen auf andere Bauteile eines Ultraschall-Drahtbonders zu verhindern, können die Aufhängungen 5, 6; 7, 8 in Querrichtung zum Ultraschall-Transducer 1 auch elastisch und/oder schwingungsdämpfend ausgebildet sein. Erreicht wird dies dadurch, dass die Aufhängungen 5, 6, 7, 8 jeweils aus einem senkrecht aus dem Schwingungsübertragerarm 2, 3 hervorstehenden Abschnitt und einem abgewinkelten parallel zum Schwingungsübertragerarm verlaufenden Abschnitt bestehen, wobei die erforderlichen Aufnahmebohrungen 11 in das jeweilige Ende des abgewinkelten Abschnitts eingearbeitet sind.

Der erfindungsgemäße Ultraschall-Transducer 1 bietet weiterhin die besondere Möglichkeit, auch Querschwingungen des Bondwerkzeuges, oder auch Quer- und Längsschwingungen auf einfache Weise erzeugen zu können.

Erreicht werden kann dies dadurch, dass als Ultraschall-Schwingungserzeuger zwei nebeneinander am Ultraschall-Transducer 1 befestigte Stapel von elektrostriktiven Piezoelementen verwendet werden. Werden diese Piezoelemente gegenphasig erregt, so wird eine Schwingung des schmalen Endes des Ultraschall-Transducers 1 und damit des dort eingespannten Bondwerkzeuges quer zur Längsachse des Ultraschall-Transducers 1 erreicht.

Die gleiche Wirkung wird erreicht, wenn jedem Schwingungsübertragungsarm 2, 3 ein Teilstapel mit elektrostriktiven Piezoelementen mit unterschiedlicher Phasenlage zugeordnet wird. In diesem Fall können beide Stapel gleichphasig angeregt werden, wobei die in die Schwingungsübertragerarme eingeleiteten Ultraschall-Schwingungen eine Phasenverschiebung von 180 ° aufweisen.

### Bezugszeichenliste

- 1: Ultraschall-Transducer
- 2: Schwingungsübertragerarm
- 3: Schwingungsübertragerarm
- 4: Schlitz
- 5: Aufhängung
- 6: Aufhängung
- 7: Aufhängung
- 8: Aufhängung
- 9: Aufnahme
- 10: Schwingungseinkoppelfläche
- 11: Aufnahmebohrung

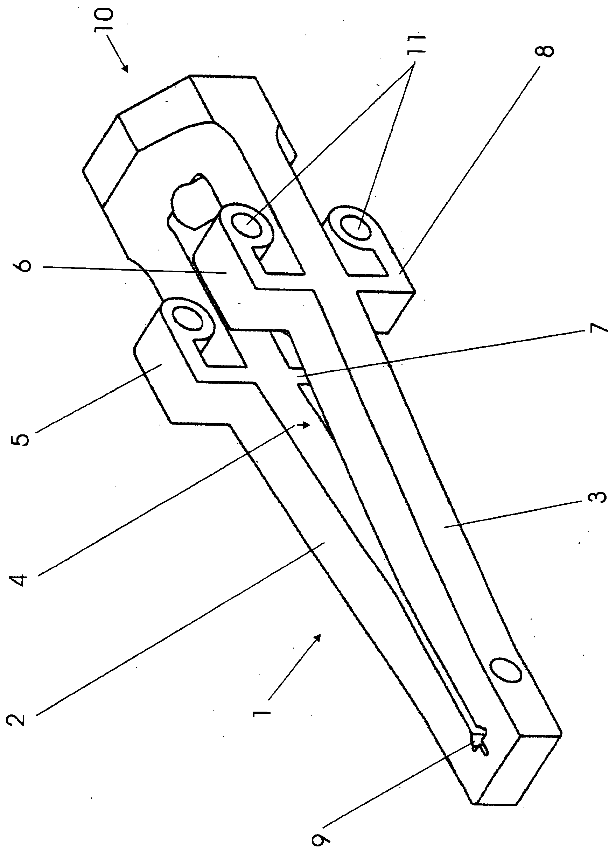

## Patentansprüche

1. Ultraschall-Transducer, der einerseits mit einem Ultraschall-Schwingungserzeuger und andererseits an seinem schmaleren Ende mit einem Ultraschall-Drahtbondwerkzeug verbindbar ist und für Ultraschall-Drahtbonder zum Herstellen von Schweißverbindungen zwischen einem Bondkontakt und einem Bonddraht vorgesehen ist, **dadurch gekennzeichnet,dass** der Ultraschall-Transducer (1) zwei senkrecht aufeinander stehende Symmetrieebenen aufweist, dass zwei sich nebeneinander erstreckende Schwingungsübertragerarme (2, 3) vorgesehen sind, die gemeinsam den Ultraschall-Transducer (1) bilden, dass die Schwingungsübertragerarme (2, 3) beidends einstückig miteinander verbunden sind und dass sich zwischen den Schwingungsübertragerarmen (2, 3) ein durch die horizontale Symmetrieebene verlaufender und zum Hindurchführen des Bonddrahtes in einem variablen Winkelbereich vorgesehener Schlitz (4) erstreckt.

2. Ultraschall-Transducer nach Anspruch 1, **dadurch gekennzeichnet,dass** der Querschnitt der Schwingungsübertragerarme (2, 3) über deren gesamten Länge im wesentlichen konstant ist.

3. Ultraschall-Transducer nach Anspruch 1 und 2, d adurch **gekennzeichnet,dass sich der** Ultraschall-Transducer (1) zur Erzeugung einer Schwingungstransformation in mindestens einer der Symmetrieebenen verjüngt.

4. Ultraschall-Transducer nach einem der Ansprüche 1 bis 3, **dadurch gekennzeichnet,dass** wenigstens zwei aus der horizontalen Symmetrieebene hervorstehende und in jeweils einem Schwingungsknoten positionierte Aufhängungen (5, 6, 7, 8) vorgesehen sind.

5. Ultraschall-Transducer nach einem der Ansprüche 1 bis 3, **dadurch gekennzeichnet,dass** zwei nach oben und zwei nach unten aus einem Schwingungsknoten hervorstehende Aufhängungen (5, 6; 7, 8) vorgesehen sind.

6. Ultraschall-Transducer nach einem der Ansprüche 1 bis 5, **dadurch gekennzeichnet,dass** die Aufhängungen (5, 6; 7, 8) in Querrichtung zum Ultraschall-Transducer (1) elastisch und/oder schwingungsdämpfend ausgebildet sind.

7. Ultraschall-Transducer nach einem der Ansprüche 1 bis 6, **dadurch gekennzeichnet,dass** der Schlitz eine am vorderen Ende des Ultraschall-Schwingungsübertragers (1) befindliche Aufnahme (9) für das Ultraschall-Drahtbondwerkzeug einschließt, wobei das Ultraschall-Drahtbondwerkzeug quer zur Schwingungsrichtung der Ultraschall-Schwingungen montierbar ist.

8. Ultraschall-Transducer nach einem der Ansprüche 1 bis 6, **dadurch gekennzeichnet,dass** das U1traschall-Drahtbondwerkzeug am vorderen Ende des Ultraschall-Transducers (1) in dessen Längsrichtung montiert ist.

9. Ultraschall-Transducer nach einem der Ansprüche 1 bis 8, **dadurch gekennzeichnet,dass** der Ul-traschall-Tansducer (1) durch Drahterodieren hergestellt ist.

10. Ultraschall-Transducer nach einem der Ansprüche 1 bis 9, **dadurch gekennzeichnet,dass** der Ultraschall-Transducer (1) aus Titan besteht.

11. Ultraschall-Transducer nach einem der Ansprüche 1 bis 10, **dadurch gekennzeichnet,dass** als Ultraschall-Schwingungserzeuger ein einzelner Stapel von elektrostriktiven Piezoelementen am Ultraschall-Transducer (1) durch Verschrauben o.dgl. befestigt ist.

12. Ultraschall-Transducer nach einem der Ansprüche 1 bis 10, **dadurch gekennzeichnet,dass** als Ultraschall-Schwingungserzeuger zwei nebeneinander am Ultraschall-Transducer (1) befestigte Stapel von elektrostriktiven Piezoelementen vorgesehen sind, die gleichoder gegenphasig erregbar sind, so dass eine Schwingung des schmalen Endes des Ultraschall-Transducers und damit des dort eingespannten Bondwerkzeuges quer zur Längsachse des Ultraschall-Transducers (1) errzeugt wird.

13. Ultraschall-Transducer nach Anspruch 12, **dadurch gekennzeichnet,dass** jedem der Schwingungsübertragungsarme (2, 3) ein Stapel mit elektrostriktiven Piezoelementen zugeordnet ist.

14. Ultraschall-Transducer nach einem der Ansprüche 1 bis 10, **dadurch gekennzeichnet,dass** jedem Schwingungsübertragungsarm (2, 3) ein Teilstapel mit elektrostriktiven Piezoelementen unterschiedlicher Phasenlage zugeordnet ist.
